# EUROPEAN PATENT APPLICATION

(11) **EP 4 436 003 A1**
(43) Date of publication of application: **25.09.2024**
(21) Application number: 24165424.3
(22) Date of filing: 22.03.2024
(51) Int. Cl.: H02J 7/00

(54) **CHARGER AND SYSTEM HAVING THE SAME**

(30) Priority: 24.03.2023 CN 202310306182
(71) Applicant: Techtronic Cordless GP, Anderson, SC 29621 (US)
(72) Inventor: HUANG, Yu, Dongguan City (CN); WANG, Liang He, Dongguan City (CN); ZHANG, Tao, Dongguan City (CN); ZHAO, Jiang, Dongguan City (CN); YANG, Tao, Dongguan City (CN)
(74) Representative: Novagraaf Group

(57) **Abstract**

The present invention provides a charging apparatus for charging a battery pack, and a system having the charging apparatus. A blocking feature structure is provided in the charging apparatus, causing fluid to be discharged to the outside of the charging apparatus via a predetermined fluid pathway, the predetermined fluid pathway being a pathway for flow only through a fan assembly between a gas intake hole and a gas vent hole, and not through other components in the charging apparatus. Due to this configuration, a hot gas flow will not flow through and damage electronic components of the charging apparatus. Furthermore, the blocking feature structure of the present invention may also comprise a sealing ring with a step part; impurities such as dust and rainwater entering through the gas intake hole can be temporarily stored on the step part when the fan is not started, and discharged through the gas vent hole after flowing through the fan with the gas flow when the fan is started. Due to this configuration, the impurities will not contact and damage electronic components in the charging apparatus.

## Description

### Technical Field

The present invention relates to a charging apparatus for charging a battery pack. The present invention further relates to a system comprising a battery and a charging apparatus.

### Background Art

Some of the charging apparatuses currently on the market for charging battery packs are provided with a fan for cooling the battery pack; the fan will guide a flow of hot gas through the battery pack into the charging apparatus, and discharge it from the charging apparatus once it has flowed through the fan. However, after flowing through the fan, some of the hot gas flow might be unable to be led out to a gas vent hole accurately, and will instead flow inside the charging apparatus, and thus might damage electronic components in the charging apparatus. Furthermore, when no battery pack is placed on the charging apparatus, impurities such as dust and rainwater might enter the charging apparatus through a gas intake hole, and this dust and rainwater will contact electronic components in the charging apparatus and have an adverse impact on these electronic components.

Thus, there is a need to provide a charging apparatus and a system having same, in order to at least partially solve the abovementioned problem.

### Summary of the Invention

An objective of the present invention is to provide a charging apparatus for charging a battery pack, and a system having the charging apparatus. A blocking feature structure is provided in the charging apparatus, the blocking feature structure causing fluid to be discharged to the outside of a casing via a predetermined fluid pathway, the predetermined fluid pathway being a pathway for direct discharge from a gas vent hole, without any flow through other components in the charging apparatus, after flow through a fan. Due to this configuration, a hot gas flow will not flow through and damage electronic components of the charging apparatus; and impurities such as dust and rainwater entrained in the gas flow will not easily contact electronic components.

Furthermore, the blocking feature structure of the present invention may also comprise a sealing ring with a step part; impurities such as dust and rainwater entering through a gas intake hole can be temporarily stored on the step part when the fan is not started, and discharged through the gas vent hole after flowing through the fan with the gas flow when the fan is started. Due to this configuration, the impurities will not contact and damage electronic components in the charging apparatus.

According to an aspect of the present invention, a charging apparatus for charging a battery pack is provided, the charging apparatus comprising:
a casing, an interface for connecting a battery pack being formed on the casing, a gas intake hole being provided at the interface, and a gas vent hole also being provided on the casing;
a fan assembly, located in the casing and disposed between the gas intake hole and the gas vent hole,
characterized in that the charging apparatus further comprises a blocking feature structure, the blocking feature structure being arranged at least partially around a predetermined fluid pathway and causing fluid to be discharged to the outside of the casing via the predetermined fluid pathway, the predetermined fluid pathway being a pathway for flow only through the fan assembly between the gas intake hole and the gas vent hole.

In an embodiment, at least a portion of the blocking feature structure is disposed between the gas intake hole and the fan assembly, and is configured to allow fluid in the charging apparatus to enter the predetermined fluid pathway; and/or
at least a portion of the blocking feature structure is disposed between the fan assembly and the gas vent hole, and is configured to prevent fluid which has already flowed through the fan assembly from being discharged between the fan assembly and the gas vent hole.

In an embodiment, the blocking feature structure comprises a sealing ring, the sealing ring being installed on a side of the fan assembly that faces the gas intake hole, and the sealing ring preferably having an annular step part protruding radially inwards and an upright part.

In an embodiment, the charging apparatus further comprises a screen member disposed at the gas intake hole, the screen member preferably being an independent member or part of the casing.

In an embodiment, the blocking feature structure comprises a gas guiding member disposed around the gas intake hole, to guide fluid into the fan assembly.

In an embodiment, the gas guiding member defines multiple gas intake grooves pointing towards the fan, an extension direction of each gas intake groove being offset with respect to a radial extension direction of a blade of the fan.

In an embodiment, the gas guiding member comprises multiple groove position members spaced apart in a circumferential direction, each of the gas intake grooves being defined between a pair of adjacent said groove position members; the multiple gas intake grooves are preferably distributed over a region exceeding 180° in the circumferential direction, and the gas intake grooves are preferably disposed facing towards a heat sink of the charging apparatus.

In an embodiment, each groove position member comprises an inner ring wall, an outer ring wall and two side walls connected head-to-tail, wherein the inner ring wall and the outer ring wall are circumferential walls around a rotation axis, the two side walls are connected between the inner ring wall and the outer ring wall, and mutually opposed side walls of adjacent groove position members are parallel.

In an embodiment, the gas guiding member is formed on an inner surface of the casing; in particular, the gas guiding member and the fan are offset in an axial direction of the rotation axis, and the gas guiding member is preferably disposed around the gas intake hole.

In an embodiment, the blocking feature structure comprises a sealing ring installed on the fan, the sealing ring and the gas guiding member being pressed tightly together.

In an embodiment, the interface is formed on a top wall of the casing, and the gas vent hole is formed on a side wall of the casing; in particular, the charging apparatus comprises a PCB, the PCB being located at a bottom side of the gas vent hole.

In an embodiment, the fan assembly comprises a fan housing accommodating a fan, a fan gas output duct pointing towards the gas vent hole is formed on the fan housing, and the fan gas output duct is preferably formed so as to extend partially around the fan.

In an embodiment, the charging apparatus is further provided with a delivery duct member connected between the fan gas output duct and the gas vent hole.

In an embodiment, the delivery duct member extends downwards and comprises a step portion.

In an embodiment, the charging apparatus is configured to allow actuation of the fan when a battery pack is installed on the charging apparatus but the battery pack is not being charged.

In an embodiment, the gas intake hole is configured such that the gas intake hole is closed when no battery pack is engaged in a socket.

According to another aspect of the present invention, a system of a battery and a charging apparatus is provided, the system comprising the charging apparatus as described in any one of the solutions above, the battery comprising an air inlet, an air outlet and a flow path therebetween, and the air outlet being aligned with the gas intake hole, such that air flows along the flow path and cools the battery under the action of the fan assembly of the charging apparatus.

In an embodiment, the air outlet is disposed at a wiring terminal of the battery.

### Brief Description of the Drawings

To better understand the above and other objectives, features, advantages and functions of the present invention, reference may be made to the preferred embodiments shown in the drawings. In the drawings, identical reference labels denote identical components. Those skilled in the art should understand that the drawings are intended to illustrate preferred embodiments of the present invention schematically, and have no limiting effect on the scope of the present invention, and the various components in the drawings are not drawn to scale.
Fig. 1 is a schematic drawing of the combination of a charging apparatus and a battery pack according to a preferred embodiment of the present invention.
Fig. 2 is a schematic drawing of the charging apparatus in Fig. 1 on its own.
Fig. 3 is a section taken along line A-A in Fig. 2.
Fig. 4 is a partial section of the charging apparatus in Fig. 2, with the casing cut open to show the internal structure of the casing.
Fig. 5 is a schematic drawing of the fan assembly, sealing ring and screen member in Fig. 3 on their own.
Fig. 6 is a bottom view of a first casing part of the charging apparatus in Fig. 2.
Fig. 7 is a top view of some of the structure of the fan assembly and the gas guiding member of the first casing part in Fig. 6.

### Key to drawings:

charging apparatus 100
10 casing
11 second casing part
12 first casing part
121 gas intake hole
122 gas vent hole
123 gas guiding member
1231 groove position member
12311 first groove position member
1231a outer ring wall
1231b inner ring wall
1231c first side wall
1231d second side wall
1232 second groove position member
1232a side wall of second groove position member
1233 gas intake groove
124 placement site
125 interface
13 insertion pin hole
20 fan assembly
21 fan housing
211 fan gas output duct
22 fan
221 blade
30 screen member
31 supporting leg
40 sealing ring
41 step part
42 upright part
50 PCB
60 delivery duct member
61 step portion of delivery duct member
200 battery pack
201 air inlet of battery pack

### Detailed Description of the Invention

Specific embodiments of the present invention are now described in detail with reference to the drawings. The embodiments described here are merely preferred embodiments of the present invention. Based on these preferred embodiments, those skilled in the art will be able to think of other ways in which the present invention could be implemented, which likewise fall within the scope of the present invention.

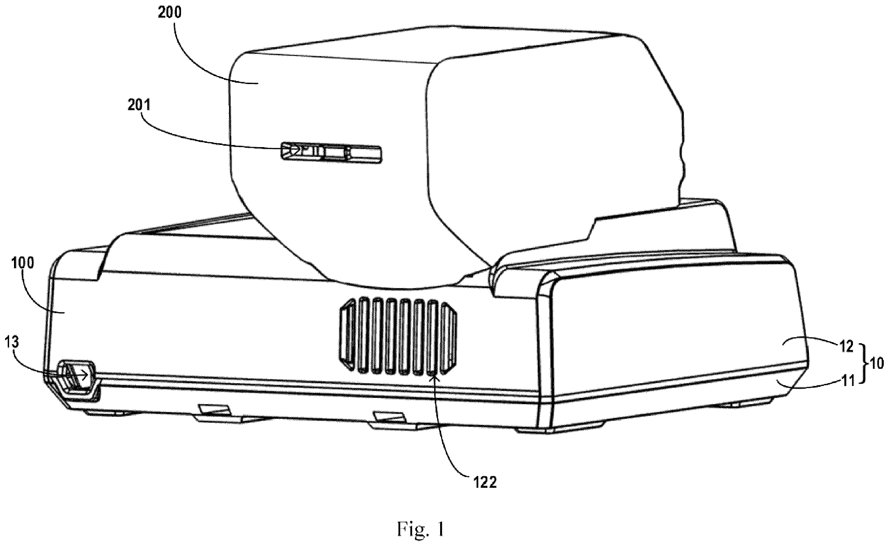

Figs. 1-7 show a charging apparatus according to some preferred embodiments of the present invention. It must first be explained that the directional and positional terms recorded in the present invention are merely used to describe relative directions and positions, rather than absolute directions and positions. These directions and positions should be understood with reference to the placement orientation of the charging apparatus when used correctly. For example, "top side", "bottom side" and "height direction" may be understood with reference to the angles of view shown for the charging apparatus in Figs. 1-5.

First referring to Figs. 1 - 3, a charging apparatus 100 in some preferred embodiments of the present invention is used to charge a battery pack 200. The charging apparatus 100 comprises a casing 10; a placement site 124 for placing the battery pack is formed on a top side of the casing 10, and an interface 125 for accommodating an insertion pin of the battery pack 200 may be provided at the placement site 124. The casing 10 is provided with a gas intake hole 121 at the placement site 124, and a gas vent hole 122 may also be provided on a side wall of the casing 10. The charging apparatus 100 is further provided with a fan assembly 20 between the gas intake hole 121 and the gas vent hole 122; the fan assembly 20 comprises a fan casing 21, and a fan 22 accommodated in the fan casing 21. An air inlet 201 and an air outlet will generally also be provided on the battery pack; the air outlet is for example disposed at a wiring terminal of the battery pack 200. The gas intake hole 121 of the charging apparatus 100 is preferably aligned with the air outlet of the battery pack. The operation of the fan 22 can achieve the effect of pumping gas, such that, under the action of a sucking force, air flows into the battery pack through the air inlet 201 of the battery pack, thereby cooling the battery pack (e.g. cells and electronic components); the flow of hot gas through the battery pack 200 flows towards the fan 22 continuously under the action of the sucking force, and a fluid pathway passing through the gas intake hole 121, the fan assembly 20 and the gas vent hole 122 in sequence is formed in the charging apparatus 100. It must be explained that the "fluid" mentioned in the present invention includes gases, liquids and solids; for example, solid and liquid particles such as dust and rainwater might be entrained in a gas.

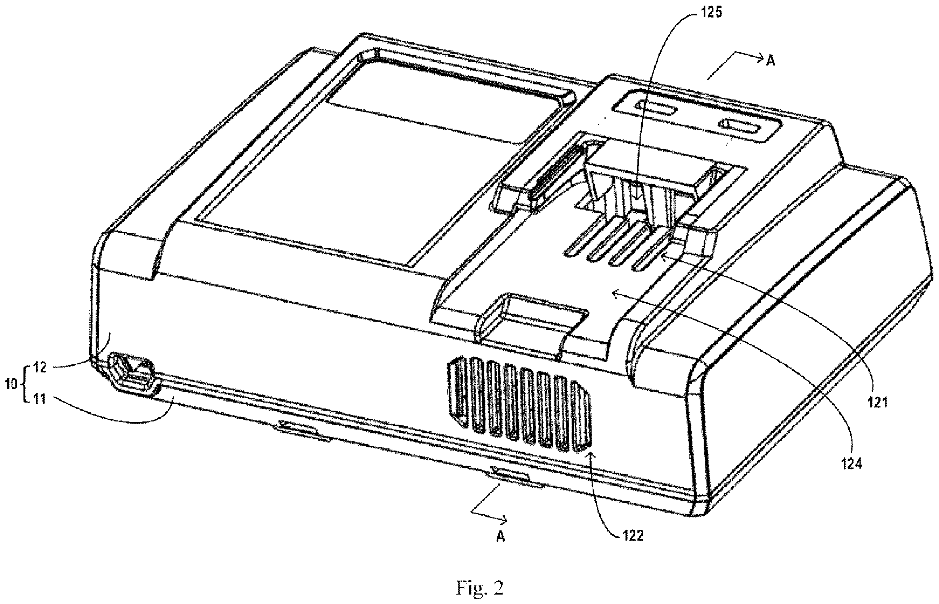

Continuing to refer to Figs. 1 and 2, in some embodiments, the casing 10 may comprise a first casing part 12 and a second casing part 11, which are butt-joined together in a height direction. The first casing part 12 comprises a top wall and a side wall, and the second casing part 11 is a base; the gas intake hole 121 and gas vent hole 122 are both formed on the first casing part 12.

The charging apparatus 100 of the present invention further comprises a blocking feature structure disposed on the fan assembly 20 and/or near the fan assembly 20; the blocking feature structure is configured such that gas which has already flowed through the fan assembly 20 is discharged through the gas vent hole 122 directly. In other words, the blocking feature structure at least partially surrounds a predetermined fluid pathway and causes fluid to be discharged to the outside of the casing 10 through the predetermined fluid pathway, the blocking feature structure being able to restrict fluid to the predetermined fluid pathway. The predetermined fluid pathway is a pathway for the flow of fluid only through the fan assembly 20 between the gas intake hole 121 and gas vent hole 122, and not through other components in the charging apparatus 100.

In some preferred embodiments, a portion of the blocking feature structure is disposed between the gas intake hole 121 and the fan assembly 20, and is configured to prevent fluid which has already flowed through the fan assembly 20 from being discharged between the gas intake hole 121 and the fan assembly 20. These examples of the blocking feature structure are discussed below with reference to the drawings.

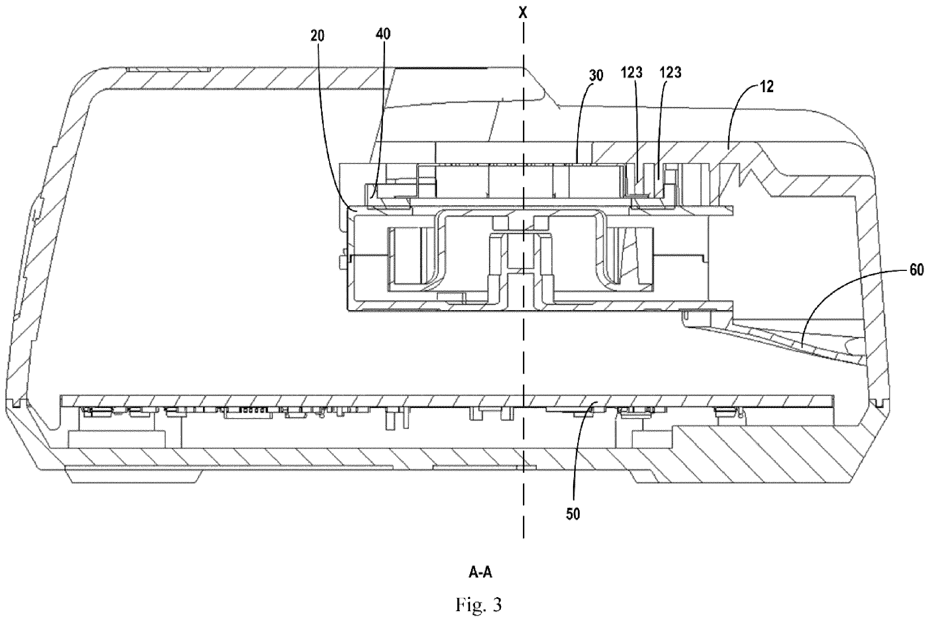

The blocking feature structure may comprise a sealing ring 40. Referring to Figs. 3-5, the sealing ring 40 is installed on a side of the fan 22 that faces the gas intake hole 121, and pressed tightly against a bottom surface of the first casing part 12. In particular, as can be seen from Fig. 3, the first casing part 12 has a gas guiding member 123 which projects towards the fan 22, the gas guiding member 123 being pressed tightly against the sealing ring 40; thus, fluid entering the charging apparatus 100 through the gas intake hole 121 will reach the fan assembly 20 directly, and will not flow through other places in the charging apparatus 100.

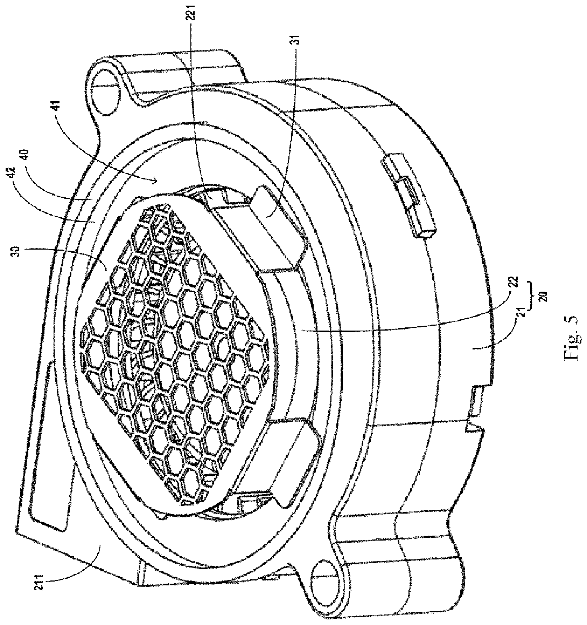

Preferably, referring to Fig. 5, the sealing ring 40 has an annular step part 41 protruding radially inwards, for the purpose of forming sealing between the gas guiding member 123 and the fan casing 21, so as to restrict fluid to the predetermined pathway more effectively. The sealing ring 40 further comprises an upright part 42 extending upwards from the step part 41. The upright part 42 accommodates the gas guiding member 123. The gas guiding member 123 is pressed tightly against the step part 41. It will be understood that the gas guiding member 123 may be an independent member, or formed integrally with the casing. A screen member 30 is also installed at a position near or immediately adjacent to the gas intake hole 121, to prevent larger-particle impurities from entering the interior of the charging apparatus. The screen member 30 may be mounted to the charging apparatus casing or formed integrally with the charging apparatus casing, or the screen member 30 is provided with supporting legs 31 and supported on the step part 41. To further prevent impurities from entering the charging apparatus 100, the gas intake hole 121 may be configured to be closable; for example, a normally closed cover may be provided to block the gas intake hole 121. The cover may be pushed open when a battery is inserted, and the cover blocks the gas intake hole again when the battery is removed. In an embodiment, when it is sensed that there is no battery pack on the placement site 124, the gas intake hole 121 may be closed; and when it is sensed that a battery pack has been placed at the placement site 124, the gas intake hole 121 is opened.

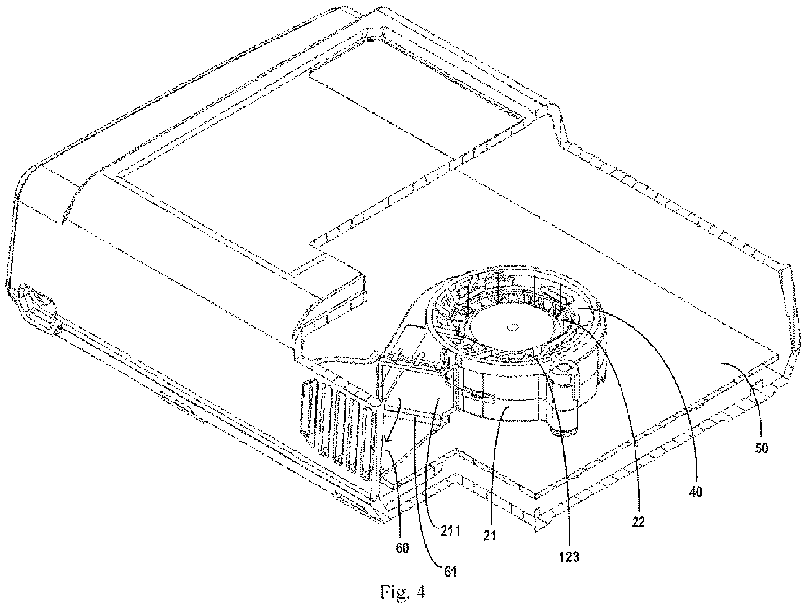

In some embodiments, the blocking feature structure may further comprise a portion disposed between the fan assembly 20 and the gas vent hole 122, this portion being configured to prevent fluid which has already flowed through the fan assembly 20 from being discharged between the fan assembly 20 and the gas vent hole 122; this portion for example comprises a fan gas output duct 211 and a delivery duct member 60, which are shown in Figs. 3 - 5. As shown in Fig. 4, the delivery duct member 60 extends substantially downwards, such that any impurities and water that might be present can be easily discharged through the gas vent hole 122. Optionally, a step portion 61 is formed at a position where the delivery duct member 60 and the fan gas output duct 211 are joined together. The step portion 61 helps to prevent any impurities and water that might be present from entering the fan assembly in the backwards direction.

The structure described above can prevent fluid which has entered through the gas intake hole from entering the interior of the charging apparatus and contacting electronic devices, and at the same time provides cooling for the battery, thus improving the performance of the charging apparatus.

In some preferred embodiments, the fan assembly 20 may also be used to cool the charging apparatus. In this case, a second fluid pathway must be provided. For example, the casing 10 of the charging apparatus 100 is non-gastight, i.e. in addition to the gas intake hole 121 and the gas vent hole 122, the casing 10 also has other, additional gas channels which connect the interior of the charging apparatus 100 to the outside, e.g. an insertion pin hole 13 as shown in Fig. 1; preferably, a labyrinth structure is provided near the insertion pin hole 13, to prevent particles from entering easily. Due to the presence of these additional gas channels, when the fan 22 rotates, gas at various locations inside the charging apparatus 100 will be sucked towards the fan assembly 20, and discharged through the gas vent hole 122 after flowing through the fan assembly 20. Correspondingly, the blocking feature structure may provide an inlet (see the detailed description below), to allow fluid in the charging apparatus 100 to enter the predetermined fluid pathway.

That is to say, a flow of gas to the fan assembly 20 may have two sources: a first gas flow entering the charging apparatus 100 from the battery pack 200 via the gas intake hole 121; and a second gas flow entering the charging apparatus 100 through the additional gas channels and possibly flowing through other components in the charging apparatus 100. It will be understood that when the fan 22 is operating, a flow of gas will be continuously sucked into the charging apparatus 100 through the additional gas channels, flow through electronic components of a PCB 50, for example, and then flow into the fan assembly 20, such that the electronic components of the PCB 50, etc. are cooled, and are thus able to maintain good performance.

Specifically, the configuration of the gas guiding member 123 can enable the flow of gas from the additional gas channels to be guided to the fan assembly 20 via a specific pathway, and at the same time can prevent gas which has already flowed through the fan assembly 20 from flowing out of the fan assembly again through this pathway. The gas guiding member 123 is provided with multiple gas intake grooves 1233. The gas intake grooves 1233 form channels in communication with the interior of the charging apparatus, such that the second gas flow from the charging apparatus can enter the predetermined fluid pathway under the action of the fan. Referring to Fig. 3, the upright part 42 of the sealing ring covers a lower part of the gas intake grooves 1233, such that water entering through the gas intake hole will not flow into the charging apparatus. Optionally, multiple gas intake grooves 1233 are configured to face towards a heat sink (not shown) of the charging apparatus, such that air heated by the heat sink can be sucked into the fan assembly over a shorter distance and discharged.

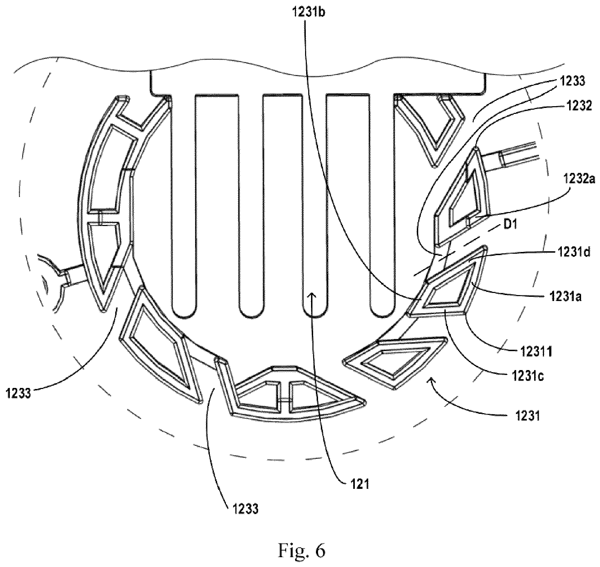

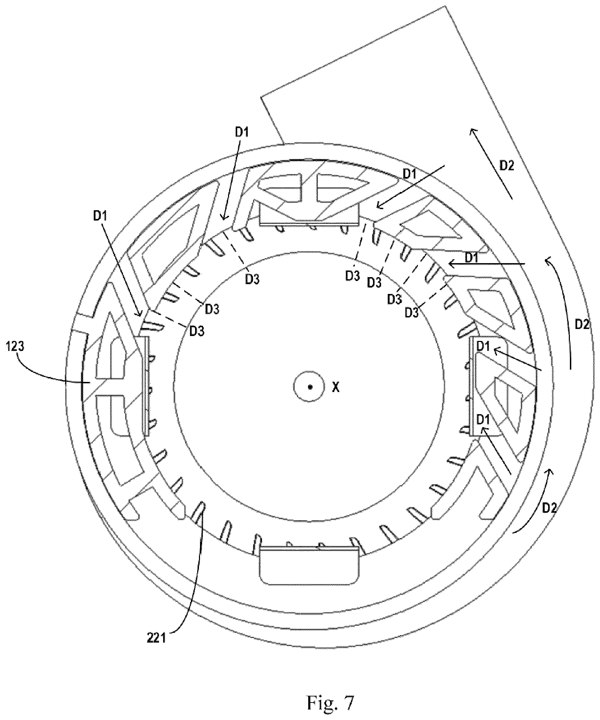

Referring to Figs. 4, 6 and 7, in some embodiments, the gas guiding member 123 is arranged around a rotation axis X of the fan 22, and is located at an outer side of the fan 22 in a circumferential direction. The gas guiding member 123 defines multiple gas intake grooves 1233 pointing towards the fan 22, and an extension direction of each gas intake groove is offset with respect to a radial extension direction of a blade 221 of the fan 22. Referring to Figs. 6 and 7, an extension direction, in a radial plane, of the gas intake groove is indicated by D1; an extension direction, in a radial plane, of a gas pathway defined by the adjacent blade 221 of the fan 22 is indicated by D3 (as will be understood, the radial extension direction of the blade 221 is parallel to direction D3); and an included angle less than 180° is formed between direction D1 and direction D3. Due to this configuration, when the fan 22 rotates, water or impurities entering through the gas intake hole by chance will not be able to directly enter the interior of the charging apparatus through the gas intake grooves 1233 when blown and beaten by the fan. Such water or impurities, after striking a wall part of the gas intake groove 1233, will return to the predetermined fluid pathway under the action of the second gas flow. The arrows labelled D1 in Fig. 7 indicate the directions of pathways, into the fan assembly 20, of gas from the additional gas channels that might flow through the electronic components of the PCB 50, for example.

A specific configuration of the gas guiding member 123 is shown in Fig. 6. Referring to Fig. 6, the gas guiding member 123 comprises multiple groove position members 1231 spaced apart in the circumferential direction, each gas intake groove 1233 being defined between a pair of adjacent groove position members 1231; preferably, the multiple groove position members 1231 are distributed over a region exceeding 180° in the circumferential direction. That is to say, the multiple gas intake grooves 1233 are provided throughout a range exceeding 180° around the fan 22. The gas intake grooves 1233 are disposed obliquely in the opposite direction to an operating rotation direction of the fan (in Fig. 6, the fan operates by rotating clockwise). Due to this oblique configuration, water blown and beaten by the fan cannot directly escape from the gas intake grooves 1233 and enter the interior of the charging apparatus. Taking one of the groove position members, 12311, as an example, the groove position member 12311 comprises an inner ring wall 1231b, a first side wall 1231c, an outer ring wall 1231a and a second side wall 1231d which are connected head-to-tail. The inner ring wall 1231b and outer ring wall 1231a are circumferential walls around the rotation axis X, wherein the circumferential size of the inner ring wall 1231b is smaller than that of the outer ring wall 1231a. The other groove position members 1231 have configurations similar to that of the groove position member 12311. Taking a pair of adjacent groove position members 12311, 1232 as an example, mutually opposed side walls 1231d, 1232a of the pair are parallel, and a gas intake groove extending in direction D1 in the radial plane is defined between the side walls 1231d, 1232a.

In some embodiments, the gas guiding member 123 is disposed on the bottom surface of the first casing part 12 in an integrally formed manner; due to this configuration, the gas guiding member 123 is located above the fan assembly 20. It will be understood that the gas guiding member 123 is disposed around the fan assembly 20 in the circumferential direction, but the gas guiding member 123 and the fan assembly 20 are offset in an axial direction. Preferably, the gas guiding member 123 and the sealing ring 40 can act cooperatively. For example, as stated above, the gas guiding member 123 may be pressed tightly against the sealing ring 40. The combination of the gas guiding member 123 and the sealing ring 40 only allows gas to flow into the fan assembly 20, preventing gas at the fan assembly 20 from leaving the fan assembly 20 via the gas guiding member 123 and sealing ring 40.

Furthermore, the configuration of groove positions of the gas guiding member 123 can also prevent particles such as dust and rainwater from entering the charging apparatus 100 from the top of the fan assembly 20. It will be understood that when the fan 22 is rotating, even if dust and rainwater are picked up by the gas flow, the impurities will not be able to leave the sealing ring 40 via the gas intake grooves of the gas guiding member 123, because the gas intake grooves 1233 of the gas guiding member 123 are not aligned with the blades 221 of the fan 22. When the fan 22 is rotating, impurities enter the fan 22 together with the gas, and are finally discharged through the gas vent hole 122.

Likewise preferably, as the gas guiding member 123 is disposed around the gas intake hole 121, two fluid sources (mainly gas sources) mix together initially when entering the fan assembly 20; consequently, the fluid agitated by the blades 221 of the fan 22 is more uniform, and the discharged fluid is able to have a stable flow speed.

In other embodiments which are not shown, the gas guiding member may have other configurations. For example, the gas guiding member may be disposed independently of the casing, or spaced apart from the gas intake hole; the gas guiding member not only surrounds the fan assembly in the circumferential direction, but may also have a region of overlap with the fan assembly in the axial direction; the gas guiding member may also define a curved or bent gas intake channel, to further prevent back-flow of fluid; the groove position members may not be provided with circumferential walls, only being provided with walls which extend partially in radial directions. The fan gas output duct 211 is formed on a housing of the fan 22 and points towards the fan 22 of the gas vent hole 122; preferably, the fan gas output duct 211 is formed so as to partially surround the fan 22 (see Fig. 7), such that fluid discharged from various positions all around the fan 22 can be collected in the fan gas output duct 211 and discharged by the fan gas output duct 211. The direction of the path of fluid leaving the fan assembly 20 is indicated by the arrows D2 in Fig. 7. The delivery duct member 60 is connected between the gas vent hole 122 and the fan gas output duct 211 of the fan 22. The fan gas output duct 211 and delivery duct member 60 can prevent fluid from flowing between the fan 22 and the gas vent hole 122 to other regions in the charging apparatus 100, such that fluid flowing through the fan 22 can only be directly delivered to the gas vent hole 122. The path of fluid flowing through the fan gas output duct 211 and delivery duct member 60 is indicated by the arrow in Fig. 4. The configuration of the fan gas output duct 211 and delivery duct member 60 can also serve to support impurities, facilitating the discharge of impurities.

In addition to the various configurations of the blocking feature structure mentioned in the embodiments above, the blocking feature structure may also have other forms of implementation in other embodiments which are not shown. For example, the blocking feature structure may comprise a duct structure connected between the gas intake hole and the fan assembly, the duct structure guiding fluid from the gas intake hole into the fan assembly directly; or the fan assembly may be disposed near the gas vent hole, and the blocking feature structure may also comprise a structure such as a sealing ring disposed between the fan assembly and the gas vent hole.

The present invention may also have preferred configurations in other respects. For example, the charging apparatus 100 may be configured such that when the battery pack is inserted in the charging apparatus, the fan 22 can be actuated so as to cool the battery pack even if charging is not performed (for example, the battery pack is already fully charged, or the charging function has not been activated). For example, the charging apparatus may determine battery overheating by detecting or obtaining battery temperature, and then start the fan to cool the battery. Alternatively, the charging apparatus may start the fan to cool the battery on the basis of a battery request. Once the battery temperature has entered a normal state, battery charging may be continued. This configuration allows a battery pack, which is overheated but does not require charging, to be installed on the placement site 124 of the charging apparatus 100 by a user; the sucking action of the fan 22 causes a hot gas flow to be sucked in continuously from the battery pack, and cold air enters the battery pack continuously from the outside to achieve the objective of cooling the battery pack. Likewise preferably, the PCB 50 in the charging apparatus 100 is disposed far away from the fluid pathway of the hot gas flow in the charging apparatus 100; for example, the PCB 50 may be disposed below the gas vent hole 122.

The present invention further provides a system, the system for example comprising the charging apparatus 100 and a battery 200, wherein the charging apparatus 100 and the battery 200 may be combined and sold as a set. The above description of specific embodiments of the charging apparatus 100 and battery pack 200 of the present invention should also be regarded as a description of specific embodiments of the system of the present invention.

Based on the above discussion of embodiments of the present invention, it can be seen that the blocking feature structure in the charging apparatus of the present invention can restrict fluid from leaving the predetermined fluid pathway, the predetermined fluid pathway being a pathway for direct discharge from the gas vent hole, without any flow through other components in the charging apparatus, after flow through the fan. Due to this configuration, the hot gas flow will not flow through and damage electronic components of the charging apparatus. Furthermore, the blocking feature structure of the present invention may also comprise the sealing ring with the step part; impurities such as dust and rainwater entering through the gas intake hole can be temporarily stored on the step part when the fan is not started, and discharged through the gas vent hole after flowing through the fan with the gas flow when the fan is started. Due to this configuration, the impurities will not contact and damage electronic components in the charging apparatus.

The above description of various embodiments of the present invention is provided for descriptive purposes to a person skilled in the art. It is not intended that the present invention be exclusive or limited to a single disclosed embodiment. As above, those skilled in the field of the above teaching will understand various alternatives and variants of the present invention. Thus, although some alternative embodiments have been specifically described, those skilled in the art will understand, or develop with relative ease, other embodiments. The present invention is intended to include all alternatives, modifications and variants of the present invention described here, as well as other embodiments which fall within the spirit and scope of the present invention described above.

## Claims

1. Charging apparatus (100) for charging a battery pack (200), the charging apparatus comprising:
a casing (10), an interface (125) for connecting a battery pack being formed on the casing, a gas intake hole (121) being provided at the interface, and a gas vent hole (122) also being provided on the casing;
a fan assembly (20), located in the casing and disposed between the gas intake hole and the gas vent hole,
**characterized in that** the charging apparatus further comprises a blocking feature structure, the blocking feature structure being arranged at least partially around a predetermined fluid pathway and causing fluid to be discharged to the outside of the casing via the predetermined fluid pathway, the predetermined fluid pathway being a pathway for flow only through the fan assembly between the gas intake hole and the gas vent hole.

2. Charging apparatus according to Claim 1, **characterized in that** at least a portion of the blocking feature structure is disposed between the gas intake hole (121) and the fan assembly (20), and is configured to allow fluid in the charging apparatus to enter the predetermined fluid pathway; and/or
at least a portion of the blocking feature structure is disposed between the fan assembly (20) and the gas vent hole (122), and is configured to prevent fluid which has already flowed through the fan assembly from being discharged between the fan assembly (20) and the gas vent hole (122).

3. Charging apparatus according to Claim 1 or 2, **characterized in that** the blocking feature structure comprises a sealing ring (40), the sealing ring being installed on a side of the fan assembly (20) that faces the gas intake hole (121), and the sealing ring (40) preferably having an annular step part (41) protruding radially inwards and an upright part (42).

4. Charging apparatus according to Claim 3, **characterized by** further comprising a screen member (30) disposed at the gas intake hole (121), the screen member (30) preferably being an independent member or part of the casing.

5. Charging apparatus according to any one of Claims 1-4, **characterized in that** the blocking feature structure comprises a gas guiding member (123) disposed around the gas intake hole, to guide fluid into the fan assembly.

6. Charging apparatus according to Claim 5, **characterized in that** the gas guiding member (123) defines multiple gas intake grooves (1233) pointing towards the fan, an extension direction (D1) of each gas intake groove being offset with respect to a radial extension direction of a blade (221) of the fan (22).

7. Charging apparatus according to Claim 5, **characterized in that** the gas guiding member (123) comprises multiple groove position members (1231) spaced apart in a circumferential direction, each of the gas intake grooves being defined between a pair of adjacent said groove position members; the multiple gas intake grooves are preferably distributed over a region exceeding 180° in the circumferential direction, and the gas intake grooves are preferably disposed facing towards a heat sink of the charging apparatus.

8. Charging apparatus according to Claim 7, **characterized in that** each groove position member (1231) comprises an inner ring wall (1231b), an outer ring wall (1231a) and two side walls (1231c, 1231d) connected head-to-tail, wherein the inner ring wall and the outer ring wall are circumferential walls around a rotation axis (X), the two side walls are connected between the inner ring wall and the outer ring wall, and mutually opposed side walls (1231d, 1232a) of adjacent groove position members (1231) are parallel.

9. Charging apparatus according to any one of Claims 5 - 8, **characterized in that** the gas guiding member (123) is formed on an inner surface of the casing; in particular, the gas guiding member (123) and the fan (22) are offset in an axial direction of the rotation axis (X), and the gas guiding member (123) is preferably disposed around the gas intake hole (121).

10. Charging apparatus according to Claim 9, **characterized in that** the blocking feature structure comprises a sealing ring (40) installed on the fan, the sealing ring (40) and the gas guiding member (123) being pressed tightly together.

11. Charging apparatus according to any one of Claims 1 - 10, **characterized in that** the interface (125) is formed on a top wall of the casing, and the gas vent hole (122) is formed on a side wall of the casing; in particular, the charging apparatus comprises a PCB (50), the PCB being located at a bottom side of the gas vent hole (122).

12. Charging apparatus according to any one of Claims 1 - 11, **characterized in that** the fan assembly (20) comprises a fan housing (21) accommodating a fan (22), a fan gas output duct (211) pointing towards the gas vent hole is formed on the fan housing, and the fan gas output duct (211) is preferably formed so as to extend partially around the fan.

13. Charging apparatus according to Claim 12, **characterized in that** the charging apparatus is further provided with a delivery duct member (60) connected between the fan gas output duct (211) and the gas vent hole (122);
preferably, the delivery duct member (60) extends downwards and comprises a step portion.

14. Charging apparatus according to any one of Claims 1 - 13, **characterized in that** the charging apparatus is configured to allow actuation of the fan when a battery pack is installed on the charging apparatus but the battery pack is not being charged;
preferably, the gas intake hole (121) is configured such that the gas intake hole is closed when no battery pack is engaged in a socket.

15. System of a battery and a charging apparatus, the system comprising the charging apparatus according to any one of Claims 1 - 14, the battery comprising an air inlet, an air outlet and a flow path therebetween, and the air outlet being aligned with the gas intake hole (121), such that air flows along the flow path and cools the battery under the action of the fan assembly of the charging apparatus, wherein the air outlet is disposed at a wiring terminal of the battery.
